(19) Europäisches Patentamt

European Patent Office

Office européen des brevets

(11) **EP 1 713 119 A2**

(12) **EUROPEAN PATENT APPLICATION**

(43) Date of publication:
**18.10.2006 Bulletin 2006/42**

(51) Int Cl.:
*H01L 21/311* (2006.01)    *H01L 21/66* (2006.01)

(21) Application number: **06007580.1**

(22) Date of filing: **11.04.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **11.04.2005 EP 05425206**

(71) Applicant: STMicroelectronics S.r.l.
**20041 Agrate Brianza (Milano) (IT)**

(72) Inventors:
 • **Fazio, Giuseppe**
  **20065 Inzago (Milano) (IT)**
 • **Spandre, Alessandro**
  **27100 Pavia (IT)**
 • **Petruzza, Pietro**
  **20060 Pessano con Bornago (Milano) (IT)**

(74) Representative: **Ferrari, Barbara**
 **Botti & Ferrari S.r.l.,**
 **Via Locatelli, 5**
 **20124 Milano (IT)**

(54) **Method for patterning a wafer for the manufacture of an integrated circuit**

(57)    The present invention relates to a method for patterning a film of silicon nitride (14) landing over a silicon oxide substrate (12) for the manufacture of an integrated circuit. The method comprises the steps of:
- etching at least one portion of a silicon nitride (14) surface with plasma (15) containing $Cl_2$, $BCl_3$ and $CHF_3$, whereby performing an etching reaction to define tapered trenches within the silicon nitride (14), wherein the plasma further comprises an inert gas which is indifferent in the etching reaction,
- monitoring an infrared frequency emission signal (16) resulting from etching reaction products;
- correlating a variation of the infrared frequency emission signal (16) with an etching across an interface area between the silicon nitride (14) and the silicon oxide substrate (12).

Fig.1A

EP 1 713 119 A2

Fig.1B

**Description**

Field of application

The present invention relates in its more general aspect to the manufacture of electronic semiconductor devices and more particularly to a method for patterning a wafer for the manufacture of an integrated circuit.

Prior art

The manufacture of electronic semiconductor devices is performed by exposing silicon wafers to a series of chemical-physical treatments, allowing integrated circuits to be defined on the surface thereof, such as for example a memory cell.

In particular, in order to define submicrometric patterns on a wafer substrate a widerly used process technique is the reactive gas plasma etching (low-pressure ionised gas).

This technique is an anisotropic process allowing the substrate material to be removed by following a preferential direction, in most cases corresponding to the perpendicular direction of the substrate to be etched.

A problem associated to the reactive gas plasma etching method is the difficulty to detect a predetermined and point of the etching step, i.e. the moment when a predetermined amount, or a whole substrate has been removed obtaining a full substrate etching.

A technique to check the end point of an etching step is the one adopting the optical emission spectroscopy (OES).

The optical emission spectroscopy allows the electromagnetic radiations emitted by species in non-equilibrium conditions produced by the reaction between the plasma and the substrate to be monitored.

In particular these are radiations emitted by the products of the reaction between the plasma and the substrate, corresponding to electronic transitions of molecular or atomic levels. Being electronic transitions, the radiations being emitted are detected in the range of UV frequencies.

The emission spectrum monitoring is particularly suitable to the aim, since the signal intensity varies during the substrate etching. Generally the signal considerably varies in correspondence with the end point.

Therefore, in order to detect the etching step end point, the spectral fingerprint of the radiations being emitted at a predetermined wavelength in the UV is monitored and the emission band intensity variation is checked.

OES is a technique being per se effective to check the end point of an etching step.

Nevertheless it is not always possible to detect a typical emission band in correspondence with the end point. In particular, some reactive gas plasmas being presently used do not allow a significant intensity variation of the emission signal to be detected.

As a consequence, in order to obviate this problem, it is necessary to adopt particular practical expedients when this technique is applied.

Some known methods provide to conveniently vary the reactive gas plasma, i.e. to vary the etching chemistry, during the whole etching step in order to use a different reactive gas plasma between a star point and an end point.

This last method has however the drawback to require each time the definition of new etching process parameters both from the morphological point of view and from the electric point of view. It is moreover necessary to provide different etching chemistries according to the substrate to be etched.

Other methods provide the use of more sophisticated hardware devices capable to detect more precisely the emission band intensity variation in correspondence with the end point. This method has however the drawback to require the use of more and more sophisticated hardware devices being not always compatible with the traditional instruments used in the etching process, and requiring anyway a considerable cost increase.

Both known methods has the additional drawback to be ineffective when the etching step provides the etching of a small substrate area with respect to the whole wafer, for example lower than 5%.

In this case the optical signal being emitted has a further reduced intensity since, because of the reduced etching area, the by-products that determine the radiation emission, are proportionally in a relatively reduced number.

This drawback becomes particularly evident when an etching step is performed on a silicon nitride film landing over a silicon oxide substrate by means of a plasma containing $Cl_2$, $BCl_3$ and $CHF_3$. This etching process enables to obtain tapered trenches having very small size with respect to the whole wafer.

In such a case, the plasma containing $Cl_2$, $BCl_3$ and $CHF_3$ is not selective between the silicon nitride film and the silicon oxide substrate, namely the plasma containing $Cl_2$, $BCl_3$ and $CHF_3$ indifferently etches both silicon nitride film and the silicon oxide substrate. Therefore, the small patterning area together with the non-selective etching process does not allow reliable detection of an interface between silicon nitride film and the silicon oxide substrate.

With regard to this etching process, it is also to be noted that the plasma containing $Cl_2$, $BCl_3$ and $CHF_3$ has been set up with the aim of having the peculiar tapered morphology of the trenches defined. Therefore the etching chemistry being particularly suitable for the stated purpose should not be changed.

The underlying technical problem of this invention is to provide a method for patterning a film of silicon nitride landing over a silicon oxide substrate to obtain tapered trenches, wherein the reaching of the interface between the silicon nitride film and the silicon oxide substrate can be detected.

Summary of the invention

According to the present invention, the above technical problem is solved by a method for patterning a film of silicon nitride landing over a silicon oxide substrate for the manufacture of an integrated circuit, comprising the steps of:

- etching at least one portion of a silicon nitride surface with plasma containing $Cl_2$, $BCl_3$ and $CHF_3$, whereby performing an etching reaction to define tapered trenches within the silicon nitride, and wherein the plasma further contains an inert gas that is indifferent in the etching reaction,

- monitoring an infrared frequency emission signal resulting from etching reaction products; and

- correlating a variation of the infrared frequency emission signal with an etching across an interface area between the silicon nitride and the silicon oxide substrate.

An advantage of the method according to the present invention is that from the IR signal it is possible to unequivocally determine the chemical nature of the molecular fragments produced by the reaction of the plasma with the film, i.e. of the etching reaction products, and thus to have useful indications on the reaction.

Therefore, detecting a change of the molecular fragments enables to detect the reaching of the interface. Thanks to the IR detection, the lack of selectivity in the etching process is overcome.

It is to be noted that the IR signal is enhanced, by means of the addition of, inert gas, more than UV signal during the etching step across the silicon nitride / silicon oxide substrate interface.

Accordingly, infrared frequencies are used instead of UV frequencies, notwithstanding the conventional use of electronic emissions for endpoint detection and notwithstanding electronic transitions are higher than vibrational ones.

Moreover, according to the invention, the inert gas addition has a negligible effect upon morphology and dimensions of the trenches, whereby the obtained tapered trenches are very similar to the trenches obtained by a standard process without adding any inert gas.

Further features and advantages of the method according to the invention will be apparent from the following description of an embodiment thereof given by way of non limiting example with reference to the drawings.

Brief description of the drawings

Figures 1A-1B are respective schematic views of an operative sequence of the method according to the invention.

Figure 2 shows a diagram of the in time-variation trend of the intensity of an optical emission signal at a predetermined IR frequency.

Figures 3a-3c respectively show further diagrams of the in time variation trend of the intensity of an optical emission signal at a predetermined frequency.

Fig. 4a shows an image of a trench obtained by a conventional method without the use of inert gas.

Fig. 4b shows an image of a trench obtained by a method according to an embodiment of the invention.

Detailed description

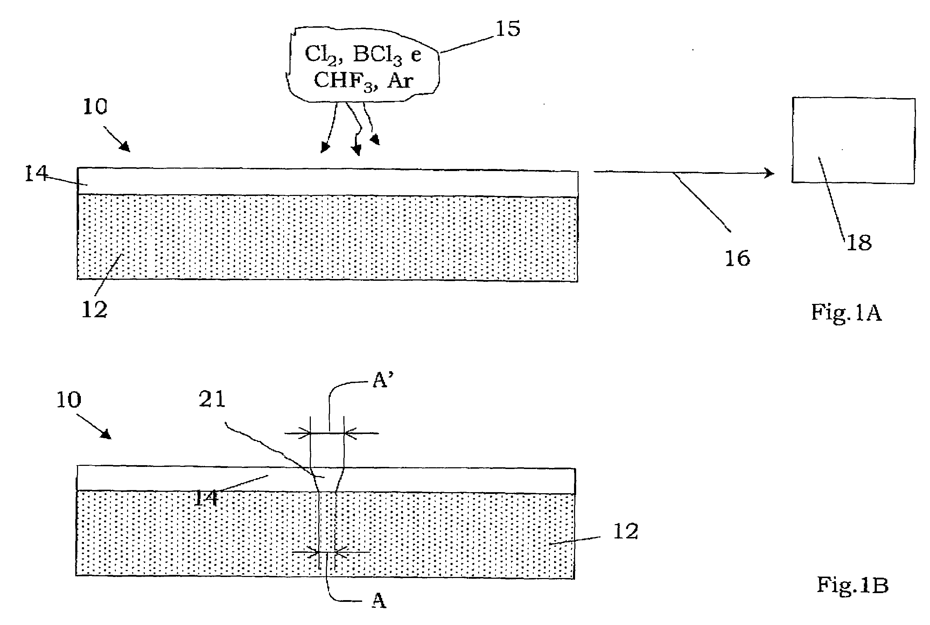

With reference to the figures, and particularly to the example of figures 1A-1B, a wafer undergoing a sequence of process steps provided by the method according to the present invention is globally and schematically indicated with 10.

The process steps and structures described hereafter do not form a complete process flow for producing integrated circuits. In fact the present invention can be implemented together with the integrated circuit manufacturing techniques presently used in this field, and only those process steps being commonly used which are necessary to understand the invention are described hereafter.

The figures representing wafer cross sections, during manufacturing, are not drawn to scale, but they are drawn instead to show the main features of the invention.

The wafer 10 comprises two layers: a first substrate forming a landing substrate 12 and a second substrate 14 positioned above the landing substrate 12.

The landing substrate 12 is made of silicon oxide, while the second substrate 14 is made of silicon nitride.

In particular, with reference to figures 1A-1B, the method according to the invention comprises the step of preparing a reactive gas plasma 15 containing $Cl_2$, $BCl_3$ and $CHF_3$. The plasma 15 further contains an inert gas that is indifferent in an etching reaction.

The method further comprises the step of etching at least one portion of a silicon nitride surface with the plasma containing inert gas, $Cl_2$, $BCl_3$ and $CHF_3$, whereby performing an etching reaction to define tapered trenches within the silicon nitride I1 (figure 1A).

During the etching step an infrared frequency emission signal 16 resulting from etching reaction products is monitored.

According to the invention, the method provides a correlation between a variation of the infrared frequency emission signal and an etching across an interface area between the silicon nitride 14 and the silicon oxide substrate 12.

The correlation can be performed thanks to the combination of the inert gas presence, which determines an increase in the impacts and collisions and thus an increase in the vibrations, and the detection of an IR spectral fingerprint.

For convenience of illustration, in accordance with the present invention, spectral fingerprint means the trend of the intensity of a IR emission signal 16 during the etching reaction detected at a predetermined typical IR wavelength.

In substance, the inert gas serves as a signal enhancer since it is capable to increase the vibrations (IR detection) made by the reactive gas plasma 15 just across the interface, notwithstanding the small areas of the tapered trenches.

An explanation of the phenomenon is made with reference to the following formulas:

$$(Eq.\ 1) \qquad A \to A^+ + e^-$$
$$(A = \text{Atom of inert gas})$$

$$(Eq.\ 2.) \qquad e^- + B\text{-}B \to .\,B\text{-}B^* + e^- \to B\ B \quad e/o \quad A^+ + B\text{-}B \to .\,B\text{-}B^* + A^+$$
$$\to B\ B$$

(B-B = it schematically indicates the substrate undergoing the etching)

Plasma emissions 15 result, as above mentioned, from the collision on the silicon nitride substrate 14 of the reactive species (ions and radicals) and electrons deriving from the species used to form plasma.

When the inert gas is added, the electrons and ions resulting from the ionisation thereof (eq. 1) can favour further collisions on the substrate (eq. 2) and thus increase the spectroscopic emission intensity.

In addition, as above referred, according to the invention, the inert gas addition determines a higher increase of the spectral fingerprint for infrared frequencies with respect to the others, when the interface is reached.

For sake of precision, at the same experimental etching conditions, the intensity increase in the IR frequency range, i.e. of the vibrational emissions, is proportionally higher than the UV one, corresponding to electronic transitions.

It must be noted that, conventionally with known, detection methods, it is not possible to detect a considerable variation of the optical emission signal in the infrared field in correspondence with the interface, since the intensity of a signal IR for vibrational transitions of small areas is considerably lower than the intensity of a signal UV.

In this case, however, due to the presence of the inert gas, an increase in the collisions, and thus in the vibrations, is obtained and consequently high vibrational transitions, even for small areas of wafer, occur. As it is known, vibrational transitions determine an increase of infrared frequency intensity.

Preferably the detection in the IR is performed in the range between 900 and 950 nm.

In particular, the detection in the infrared of the optical emission signal, besides being more effective than the detection in the UV, is important, because it allows information to be obtained with respect to a detection in the UV, i.e. information characterising the etching process.

In particular, as it is known, the absorption, or detection, IR can be typical for particular molecular fragments. For example an absorption signal IR of the link N-C (nitrogen-carbon) is different if it is an "amino" nitrogen ($CH_3NH_2$), "amidic" ($CH_3CO_2NH_2$), etc.

As a consequence, from the absorption signal IR it is possible to unequivocally determine the chemical nature of the molecular fragments produced by the reaction of the plasma 15 containing $Cl_2$, $BCl_3$ and $CHF_3$ on the silicon nitride 14, i.e. of the etching reaction products, and thus to have indications on the reaction phase.

It results that the inert gas, besides increasing the optical emission signal 16 in the IR provides new etching process indicators, i.e. it provides information about the nature of the etching reaction products.

In a preferred embodiment of the invention, the method is performed in the following operative modes.

The etching step provides a mixture of gases $Cl_2$, $BCl_3$ and $CHF_3$, whereto Ar is added.

Preferably, in the etching plasma the gases $Cl_2$, $BCl_3$, $CHF_3$ and Ar are in a ratio of 1:1.4:0.1:1 or 1:1.4:0.1:2 respectively.

However, the percentage of Ar in the plasma is comprised in a quite wide range, preferably between 10% and 50% in addition to a predetermined amount (100%) of reactive gas in the plasma 15,

Preferably, the process is performed by means of a known device LAM TCP 9600 PTX. The device is provided with a known emission spectroscopy detector.

As above mentioned, the etching step with the reactive gas plasma 15 is performed on the second substrate 14, i.e. on the silicon nitride substrate.

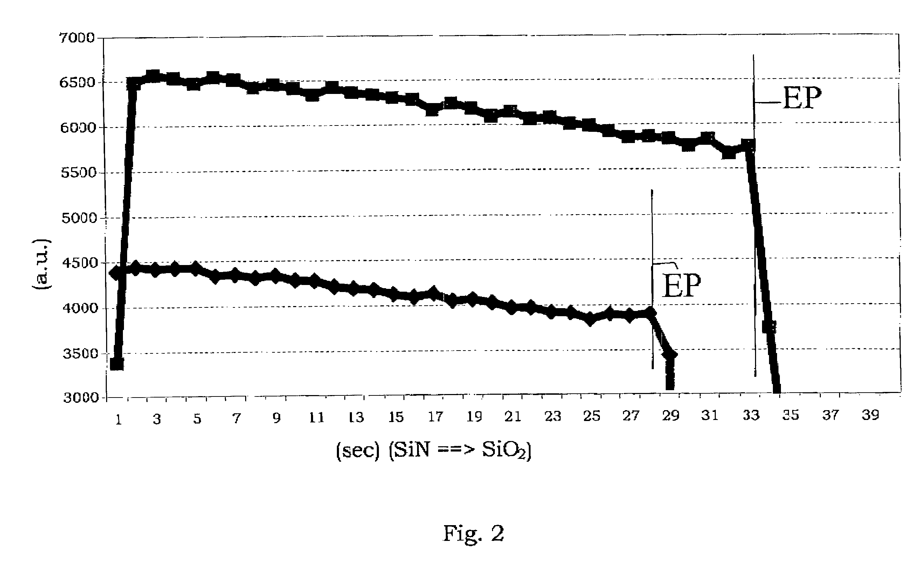

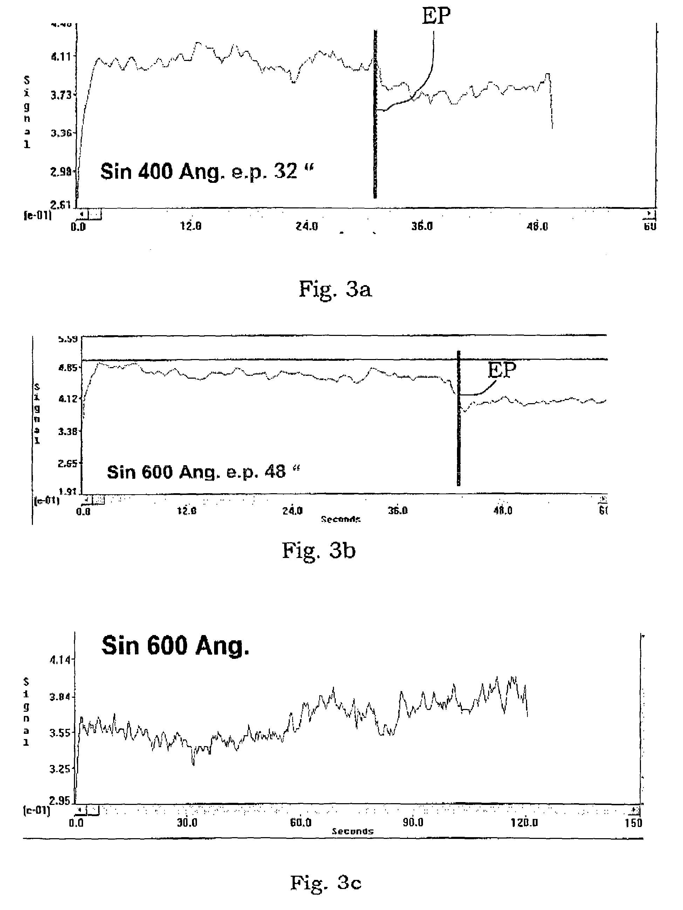

In the specific case, upon reaching the interface area between the landing substrate 12 and the second substrate 14, i.e. to the moment when an exposition of the landing substrate 12 occurs, a IR signal decrease occurs (see figures 2, 3a-2b). The interface area being reached, the optical emission signal varies according to a variation of collision by-products, of plasma 15 on the substrate 14.

As above mentioned, the detection of the optical emission signal 16 is preferably performed at 905 or 906 nm.

Said plasma 15 has an etch-rate on the silicon nitride of about 650 Å/min. Preferably, the etching on the second substrate 14 is carried on for very short times (about 40 seconds) up to the interface, so to obtain an etching 21 being about 600 Å deep in the silicon nitride.

It must be noted, as above mentioned, that the presence of an inert gas does not affect the etching process itself. In fact the inert gas does not cause a variation of the etching morphology since it is not involved in the etching process.

Moreover it must be pointed out that, actually from the experimental tests performed by the Applicant, it could be noticed that, the inert gas being present, it is possible to obtain an etching 21 having a morphology being substantially identical to an etching 21 performed without inert gas.

The following table collects the results corresponding to an etching speed variation on the substrate 14 after an amount variation of the argon inserted in the plasma 15.

In particular, four tests have been performed.

A first test wherein the plasma 15 is provided with an amount of Ar being inserted corresponding to 15%, a second test wherein the amount of Ar being inserted corresponded to 25% and a third test wherein the amount of Ar being inserted corresponded to 50%.

The results of the three test have been compared with the result of a base test (Std) wherein the plasma 15 is argon-free.

For completeness of description, it must be noted that the additions of Ar are calculated in terms of flow percentages, with respect to the reactive gas flow of the plasma 15 which is intended to be at 100%.

*Table 1.*

|  | Etching speed (Å/min) | Unif (%) |
|---|---|---|
| Std | 650 | 11 |
| (*) Std +10 %Ar | 670 | 10 |
| Std +25 % Ar | 690 | 9 |
| Std +50 % Ar | 700 | 12 |

For clarity of description the term Unif(%) indicated in table 1 means the etching percentage uniformity value on the wafer.

The uniformity is defined by measuring the etching produced by the etching in thirteen different points on the wafer and it is given by the ratio between the difference between the highest value and the lowest value (defined as spread) and twice the average of the 13 values.

The value of Unif(%) is quoted in table 1 to substantially show that the addition of Ar does not vary the etching uniformity on the substrate 14.

According to an advantage of the invention, it is possible to obtain an increase of the optical emission signal 16 even when the etched area (at the level of the interface) is relatively reduced.

In fact, according to the above-described principle, see eq. 1 and eq. 2, the amount of Ar added to the plasma 15 is sufficient to determine an increase in the collisions, and thus in the intensity of the signal 16, even when the etching area 21 is very small.

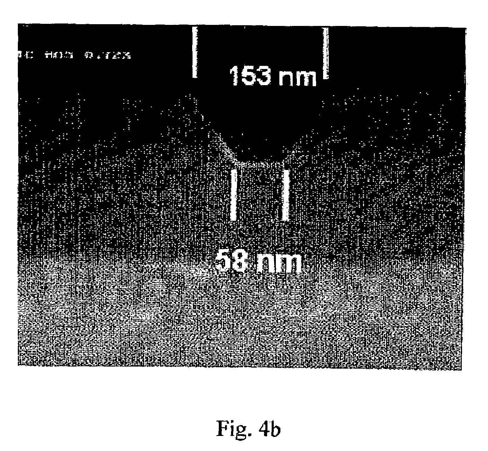

Preferably, as it can be observed in the drawings, the etching obtained with the process has a downward-tapered shape and it has a width A of about 58 nm in depth and a width A' of about 153 nm at the level of the wafer 10 surface (figure 1B, figure 4b).

The above-indicated amplitude values are about 5% with respect to the area of the whole wafer 10.

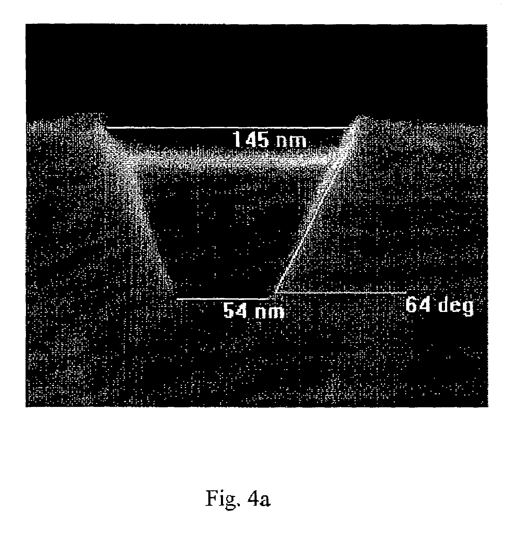

In particular Figure 4a shows the morphology of a tapered trench obtained by a standard process without the addition of any inert gas.

Figure 4b shows a tapered trench obtained by the present embodiment of the invention with the addition of inert gas (Ar). From this comparison, it can be confirmed that the inert gas addition affects neither the profile nor the dimensions of the trench.

It can thus be observed that the detection of the interface by means of the IR emission spectrum is absolutely necessary, otherwise the etching could go on beyond the interface, and thus beyond the landing substrate 12. In substance, without a considerable variation of the signal intensity, a correct etching 21 could not be obtained.

The risk of an overetching, subsequently jeopardising the device functionality, would in fact be incurred.

As a consequence, due to the method according to the invention, it is possible to determine the reaching of the interface even when the etching is not selective, or it is so to a relatively reduced extent.

Preferably in the case of the embodiment being described up to now, the method according to the invention comprises a final step, after having reached the end point, during which a selective over-etching 5:1 ($SiN:SiO_2$) is performed to clean possible SiN residuals from the bottom of the etching 21.

By way of indication, figure 2 shows the trend of the optical emission signal detected at 911 nm up to reach the interface respectively without and with inert gas in the plasma 15.

In particular, in the diagram the intensity of the optical emission signal being obtained is indicated in the ordinate, while the plasma etching time on the wafer 10, i.e. on the substrate 14 (SiN) lying on the landing substrate 12 ($SiO_2$), is indicated in the abscissa.

In order to compare the two optical signals being obtained, the etching has been performed on the same wafer 10 and in substantially identical experimental conditions, obviously except for the composition of the reactive gas plasma 15 being used.

In a first case an inert-gas-free reactive gas is used (lower signal intensity) while in a second case reactive gas plasma 15 provided with an inert gas is used, in the case being shown Ar (higher signal intensity).

Actually from figure 2 it is possible to notice an increase in the variation intensity of the signal 16 during the etching of the interface first substrate 12/second substrate 14.

It must be noted that the inert gas allows also the slope of the intensity signal to be increased in correspondence with the reaching of the interface.

In figures 3a-3b it is further possible to observe the detection of the reaching of the interface from the signal trend.

In particular figure 3a relates to an Ar etching process wherein the etching is 40 nm deep and the reaching of the interface is detected at 32 sec.

Figure 3b relates to an Ar etching process wherein the etching is 60 nm deep and the reaching of the interface is detected at 48 sec.

Figure 3c relates to an etching process without Ar addition, wherein the etching is 60 nm deep, as in the case of figure 3b, and wherein however the reaching of the interface cannot be detected. The optical emission signal being obtained has been recorded beyond 60 sec.

By analyzing figures 3a, 3b, 3c the following considerations can be drawn.

The first two cases (figures 3a and 3b) emphasize the reproducibility and reliability of the method being used, representing the idea of the invention being provided.

By adding the inert gas, independently from the thickness of the second layer 14 of SiN to be etched, the time corresponding to the reaching of the interface is proportionally reached.

In fact it must be noted that, by increasing the etching depth from 40 nm (figure 3a) to an etching of 60 nm (figure 3b), the time used proportionally increases by about 3/2 of the initial value.

In substance the highest is the depth of the obtained etching, the highest is the time required, which can be monitored, to reach the interface.

From the comparison between figures 3b and 3c, it is also possible to emphasize once more the difference between the optical emission signal obtained in case of plasma 15 provided with inert gas, or in case of inert-gas-free plasma.

The main advantage of the above-described method is of providing a fast-implementation method to detect the reaching of the interface during the etching of tapered trenches, and wherein the etched area is relatively limited.

A further advantage is that, in order to increase the signal, it is not necessary to use sophisticated computer means.

**Claims**

1.  A method for patterning a film of silicon nitride (14) landing over a silicon oxide substrate (12) for the manufacture of an integrated circuit, **characterized in that** it comprises the steps of:

    - etching at least one portion of a silicon nitride (14) surface with plasma (15) containing $Cl_2$, $BCl_3$ and $CHF_3$, whereby performing an etching reaction to define tapered trenches within the silicon nitride (14), the plasma (15) further comprises an inert gas which is indifferent in the etching reaction,
    - monitoring an infrared frequency emission signal (16) resulting from etching reaction products;
    - correlating a variation of the infrared frequency emission signal (16) with an etching across an interface area between the silicon nitride (14) and the silicon oxide substrate (12).

2.  The method of claim 1, wherein the inert gas is argon.

3.  The method of claim 2, wherein argon is 10% to 50% with respect to whole plasma (15).

4.  The method of claim 3, further comprising a final step, after having reached the interface, during which a selective overetching is performed to clean silicon nitride residuals in the trenches.

5.  The method of claim 3, wherein the tapered trenches occupy about 5% with respect to an area of the silicon nitride (14) surface.

6.  The method of claim 5, wherein each of the tapered trenches has a depth comprised between 40 nm and 60 nm.

7.  The method of claim 6, wherein each uf the tapered trenches has a width which is of about 58 nm at a level of the interface area between the silicon nitride (14) and the silicon oxide (12) substrate and of 153 nm at a level of the silicon nitride (14) surface.

Fig.1A

Fig.1B

EP 1 713 119 A2

Fig. 2

Fig. 3a

Fig. 3b

Fig. 3c

Fig. 4a

Fig. 4b